# EUROPEAN PATENT APPLICATION

(11) **EP 4 156 886 A1**
(43) Date of publication of application: **29.03.2023**
(21) Application number: 22206362.0
(22) Date of filing: 22.05.2020
(51) Int. Cl.: H10K 59/38, H10K 50/13

(54) **OLED DISPLAY PANEL WITH UNPATTERNED EMISSIVE STACK**

(30) Priority: 23.05.2019 US 201962851731 P; 08.11.2019 US 201962933046 P; 21.05.2020 US 202016880178
(62) Divisional of application: 20176156.6
(71) Applicant: Universal Display Corporation, Ewing, NJ 08618 (US)
(72) Inventor: HACK, Michael, Ewing, NJ, 08618 (US); WEAVER, Michael Stuart, Ewing, NJ, 08618 (US); THOMPSON, Nicholas J., Ewing, NJ, 08618 (US); BROWN, Julia J., Ewing, NJ, 08618 (US)
(74) Representative: Maiwald GmbH

(57) **Abstract**

Full-color display arrangements and device architectures are provided that include a stack of unpatterned organic emissive layers, with color-altering layers and down-conversion layers to provide individual sub-pixels, where the emissive stack includes not more than two distinct emissive colors.

## Description

### CROSS-REFERENCE TO RELATED APPLICATIONS

This application claims the benefit of U.S. Provisional Patent Application Serial No. 62/851,731, filed May 23, 2019, and U.S. Provisional Patent Application Serial No. 62/933,046, filed November the entire contents of which are incorporated herein by reference.

### FIELD

The present invention relates to arrangements for OLEDs including multiple unpatterned blanket layers of emissive material, and devices including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745, which are incorporated herein by reference in their entirety.

One application for phosphorescent emissive molecules is a full color display. Industry standards for such a display call for pixels adapted to emit particular colors, referred to as "saturated" colors. In particular, these standards call for saturated red, green, and blue pixels. Alternatively the OLED can be designed to emit white light. In conventional liquid crystal displays, emission from a white backlight is filtered using absorption filters to produce red, green and blue emission. The same technique can also be used with OLEDs. The white OLED can be either a single EML device or a stack structure. Color may be measured using CIE coordinates, which are well known to the art.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group, as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

As used herein, an emissive component may be described by a range of color within which all, or essentially all, of the energy emitted by the component occurs. For example, as used herein, a "red" layer, material, region, or device refers to one that emits light in the range of about 590-700nm; a "green" layer, material, region, or device refers to one that has an emission spectrum with a peak wavelength in the range of about 500-590nm; and a "blue" layer, material, or device refers to one that has an emission spectrum with a peak wavelength in the range of about 400-500nm. In some arrangements, an emissive component may be described as "deep green" when it has a peak wavelength in the range of 500-550nm. In some arrangements, an emissive component may be described as "deep blue" or "light blue". As used herein, a "deep blue" component refers to one having a peak emission wavelength that is at least about 4nm less than the peak emission wavelength of the "light blue" component. Typically, a "light blue" component has a peak emission wavelength in the range of about 465-500nm, and a "deep blue" component has a peak emission wavelength in the range of about 400-470nm, though these ranges may vary for some configurations. Some configurations may include separate emissive components that provide light blue and deep blue emission, though each component also may be referred to generally as a "blue" component. Some configurations may include separate emissive components that provide light green and deep green emission, though each component also may be referred to generally as a "green" component.

It is possible that different emissive components within one or more devices may emit the same "color" of light, i.e., red, green, blue, light, blue, deep blue, and the like, while including different materials. For example, a single device may have two "green" emissive components that may include the same or different emissive materials. Thus, a device having two blue emissive components and two green emissive components may be described as including only two colors of emissive components, although the green components may include the same or different materials or combinations thereof, and the blue components may include the same or different materials or combinations thereof. Similarly, emissive components may be described as emitting the "same color" when each emits color within a range as described above, even though they may have different emission spectra within the common range. As another example, two emissive layers may include the same hosts and dopants in different concentrations, leading the two layers to emit the "same color" but with different emission spectra.

In some cases emissive components in a device may be described in terms of the color space occupied by light emitted by the components. For example, two emissive components may be described herein as emitting "RGB colors" when each emits light of red, green, or blue (including deep and/or light blue) as defined above, but do not emit a "combination" color such as yellow or white that conventionally requires multiple RGB colors to achieve. Two components may be described as emitting "distinct RGB colors" when each emits a different RGB color. Similarly, a device may be characterized by the number of "distinct" colors, such as "distinct RGB colors" emitted by the device. As previously disclosed, a device may include multiple emissive components that emit within the same color but do not have identical emission spectra and/or use different emissive materials. For example, a device that includes only green and blue RGB emissive components may be described as including emissive components of "two distinct RGB colors" regardless of the number of individual green emissive components and/or blue emissive components in the device. Similarly, "deep blue" and "light blue" as previously disclosed are within the same "distinct RGB color" of blue, and a "deep green" emissive component is a "distinct RGB" green. A "distinct RGB color" emissive component is not a "combined" component such as a yellow or white emissive region even though such regions may include sub-layers that, by themselves, would be considered to emit a "distinct RGB color" because the total emission of the region is not a distinct RGB red, green, or blue. In this case, the combined component is made from two or more emissive components that emit a primary color within a color space and does not itself emit a primary color. For example, the RGB color space uses the primary colors of red, green, and blue to create any desired color. Within this color space, any yellow, white, or other color is defined as a combination of two or more primary colors in different relative amounts.

As used herein a "color altering" layer or other component refers to one that converts or modifies another color of light-to-light having a wavelength as specified for that color. For example, a "red" color-altering layer refers to a component that results in light transmitted through the component having a final output wavelength in the range of about 580-700nm. Examples of color-altering components include color filters, microcavities, combinations thereof, and the like. Color filters and similar components typically modify a spectrum by removing or enhancing one or more ranges of wavelengths of light to achieve a desired color. Another component that may be used to change the color of light within a device to achieve a desired output color emission as disclosed herein is a down-conversion layer, which convert photons of higher energy to lower energy to achieve a desired color.

As generally used in the art, a "sub-pixel" may refer to an emissive region, which may be a single-layer EML, a stacked device, or the like, in conjunction with any color altering layer or down-conversion layer that is used to modify the color emitted by the emissive region. As used herein, the "emissive region" of a sub-pixel refers to any and all emissive layers, regions, and devices that are used initially to generate light for the sub-pixel. A sub-pixel also may include additional layers disposed in a stack with the emissive region that affect the color ultimately produced by the sub-pixel, such as color altering layers or down-conversion layers as disclosed herein, though such layers typically are not considered "emissive layers" as disclosed herein because they do not generate the initial light within the sub-pixel. For example, a "red" sub-pixel may be formed using a "green" emissive component and a down-conversion layer or other color-altering layer that converts the initial green light generated by the emissive component to red light emitted by the sub-pixel. An unfiltered sub-pixel is one that excludes a color modifying component such as a color altering layer, but may include one or more emissive regions, layers, or devices.

In some configurations, emissive regions and/or emissive layers may span multiple sub-pixels, such as where additional layers and circuitry are fabricated to allow portions of an emissive region or layer to be separately addressable.

An emissive region as disclosed herein may be distinguished from an emissive "layer" as typically referred to in the art and as used herein. In some cases, a single emissive region may include multiple layers, such as where multiple blue emissive layers are included within an emissive region of a blue-emitting sub-pixel. As previously described, when such layers occur in an emissive region as disclosed herein, the layers may or may not be individually addressable within a single emissive stack depending upon the stack construction, such that the layers may be activated or driven individually or concurrently to produce the desired color of light for the emissive region. In other configurations, an emissive region may include a single emissive layer of a single color, or multiple emissive layers of the same color, in which case the color of such an emissive layer will be the same as, or in the same region of the spectrum as, the color of the emissive region in which the emissive layer is disposed.

As used herein, a "blanket" or "unpatterned" layer refers to one that is disposed in a continuous layer across a region of a device. Such a layer may be fabricated using a relatively large-scale mask, for example to prevent deposition over an outer non-active portion of a display. However, such a layer does not require the use of a fine metal mask, high resolution shadow mask, or other similar sub-pixel scale masking approach. As a result, a blanket or unpatterned layer generally is much less complex to fabricate than a patterned layer that is deposited using pixel or sub-pixel scale features.

More details on OLEDs, and the definitions described above, can be found in US Pat. No. 7,279,704, which is incorporated herein by reference in its entirety.

### SUMMARY

According to an embodiment, an organic light emitting diode/device (OLED) is also provided. The OLED can include an anode, a cathode, and an organic layer, disposed between the anode and the cathode. According to an embodiment, the organic light emitting device is incorporated into one or more device selected from a consumer product, an electronic component module, and/or a lighting panel.

In an embodiment, a full-color display arrangement for an organic light emitting diode (OLED) device is provided, which includes a first emissive layer comprising a blue first organic emissive material; a second emissive layer disposed in a stack with the first emissive layer and comprising a green, red, or blue second organic emissive material; a first color-altering component disposed in a stack with the first and second emissive layers; a second color-altering component configured to produce a different color than the first color-altering component; and a down-conversion layer. The arrangement may include emissive materials of not more than two distinct RGB colors.

In an embodiment, an OLED display device is provided that includes a first organic emissive layer comprising a first organic emissive material that emits light having a 1976 CIELUV u value of not more than 0.17; a second organic emissive layer comprising a second organic emissive material that emits light having a 1976 CIELUV u value of not more than 0.17and having a different color than the first organic emissive material; and a first color-altering component disposed and arranged to alter light emitted by at least one of the first and second organic emissive layers. The display may include emissive materials of not more than two distinct RGB colors.

According to an embodiment, a full-color display arrangement for an organic light emitting diode (OLED) device is presented. The full-color display arrangement comprises a first emissive layer comprising a first blue first organic emissive material; a second emissive layer disposed in a stack with the first emissive layer and comprising a second organic emissive material, wherein the second organic emissive material comprises a green organic emissive material, a red organic emissive material, or a second blue organic emissive layer having a peak wavelength at least 4nm different than the first blue organic emissive layer; comprises a first color-altering component disposed in a stack with the first and second emissive layers; and a second color-altering component configured to produce a different color than the first color-altering component; and a first down-conversion layer; wherein the full-color display arrangement comprises emissive materials of not more than two distinct RGB colors.

According to an embodiment, the second organic emissive material is a green emissive material, and wherein each of the first and second emissive materials has a 1976 CIELUV u value of not more than 0.17.

According to an embodiment, the second organic emissive material is a red emissive material, and wherein each of the first and second emissive materials has a 193 1(x,y) color space y value of not more than 0.35.

According to an embodiment, the first color-altering component is a blue color filter.

According to an embodiment, the second color-altering component is a green color filter.

According to an embodiment, the down-conversion layer is a red quantum dot layer.

According to an embodiment, the down-conversion layer is a green quantum dot layer.

According to an embodiment, a charge generation layer disposed between the first and second emissive layers is comprised.

According to an embodiment, a second down-conversion layer of a different emission color than the first down-conversion layer is comprised. Preferably, the first down-conversion layer produces green light and the second down-conversion layer produces red light.

According to an embodiment, the first blue first organic emissive material is a deep blue emissive material.

According to an embodiment, the first blue first organic emissive material is a light blue emissive material.

According to an embodiment, the arrangement comprises at least three emissive layers, and in another embodiment comprises at least four emissive layers.

According to an embodiment, a third emissive layer disposed in a stack with the first and second organic emissive layers is comprised. According to an embodiment, said third emissive layer comprises a blue organic emissive material. In an embodiment, the first color-altering component is a blue color filter, and preferably the second color-altering component is a green color filter, and even further preferably the first down-conversion layer is a red quantum dot layer.

According to an embodiment, the third organic emissive material is different than the first organic emissive material.

According to another embodiment, the third organic emissive material comprises a light blue organic emissive material.

According to another embodiment, the third organic emissive material comprises a deep blue organic emissive material.

According to another embodiment, the third organic emissive material is phosphorescent and in another embodiment the third organic emissive material is fluorescent.

According to another embodiment, the third emissive material comprises a green third organic emissive material.

According to an embodiment, the first color-altering component is a red color filter. In a preferred embodiment. In a preferred embodiment, the first down-conversion layer is a green quantum dot layer.

According to an embodiment, the second emissive layer comprises a green emissive material and the first down-conversion layer comprises a quantum dot layer that down-converts light emitted by the first organic emissive layer and/or the second organic emissive layer to red light.

According to another embodiment, the first organic emissive material is phosphorescent, and in another embodiment all emissive materials in the arrangement are phosphorescent.

According to another embodiment, the first organic emissive material is fluorescent.

According to another embodiment, the first organic emissive material, the second organic emissive material, or both comprise a thermally activated delayed fluorescence (TADF) material.

According to another embodiment, the second organic emissive material is phosphorescent.

According to another embodiment, the first color-altering component comprises a color filter, a microcavity, or a combination thereof.

According to another embodiment, the first color-altering component is disposed in a stack with a first portion of the first and second emissive layers and the second color-altering component is disposed in a stack with a second portion of the first and second emissive layers that does not overlap the first portion of the first and second emissive layers.

According to another embodiment, the first down-conversion layer is disposed in a stack with the first and second emissive layers and either the first color-altering component or the second color-altering component.

According to another embodiment, a third color-altering component configured to produce a different color than the first and second color-altering components is comprised. In a preferred embodiment thereof, each of the first, second, and third color-altering components produces one of red, green, or blue light.

According to another embodiment, a device is disclosed, which comprises a full-color display arrangement as presented herein. The device comprises a type selected from the group consisting of: a flat panel display, a computer monitor, a medical monitor, a television, a billboard, a light for interior or exterior illumination and/or signaling, a heads-up display, a fully or partially transparent display, a flexible display, a laser printer, a telephone, a mobile phone, a tablet, a phablet, a personal digital assistant (PDA), a wearable device, a laptop computer, a digital camera, a camcorder, a viewfinder, a micro-display less than 2 inches across a diagonal, a 3-D display, a virtual reality or augmented reality display, a vehicle, a video wall comprising multiple display tiled together, a theater or stadium screen, and a sign.

According to another embodiment an OLED display device is presented which comprises a first organic emissive layer comprising a first organic emissive material that emits light having a 1976 CIELUV u value of not more than 0.17; comprises a second organic emissive layer comprising a second organic emissive material that emits light having a 1976 CIELUV u value of not more than 0. 17and having a different color than the first organic emissive material; and comprises a first color-altering component disposed and arranged to alter light emitted by at least one of the first and second organic emissive layers.

According to an embodiment, in the OLED display device each of the first and second organic emissive layers is an unpatterned blanket layer that extends across an active area of the device.

According to an embodiment, in the OLED display device the first and second organic emissive layers provide a plurality of sub-pixels which together provide a full-color display. In a preferred embodiment thereof, the first and second organic emissive layers provide three sub-pixels, each of which emits a different color and which together can produce white light.

According to an embodiment, the OLED display device includes emissive materials of not more than two distinct RGB colors.

According to an embodiment, in the OLED display device the first organic emissive material, the second organic emissive material, or both comprise a thermally-activated delayed fluorescence (TADF) material.

According to an embodiment, in the OLED display device the first organic emissive material is a blue emissive material. In a preferred embodiment thereof, the first organic emissive material is fluorescent, and in another embodiment the second organic emissive material is fluorescent. In another embodiment, the first organic emissive material is phosphorescent and in a preferred embodiment, all organic emissive materials in the device are phosphorescent.

According to an embodiment, in the OLED display device the second organic emissive material is a green emissive material. In a preferred embodiment, the second organic emissive material is phosphorescent. In another embodiment, all organic emissive materials in the device are phosphorescent.

According to an embodiment, in the OLED display device the first color-altering component comprises a type selected from a group consisting of: a color filter, and a microcavity. In a preferred embodiment thereof, the device further comprises a second color-altering component and a down conversion layer. Preferably, said second color-altering component comprises a color filter, a microcavity, or a combination thereof. And in an embodiment the second color-altering component comprises a different type than the first color-altering component.

As is clear to the skilled reader, all embodiments disclosed hereinbefore van be combined with each other unless explicitly stated herein to the contrary.

### BRIEF DESCRIPTION OF THE DRAWINGS

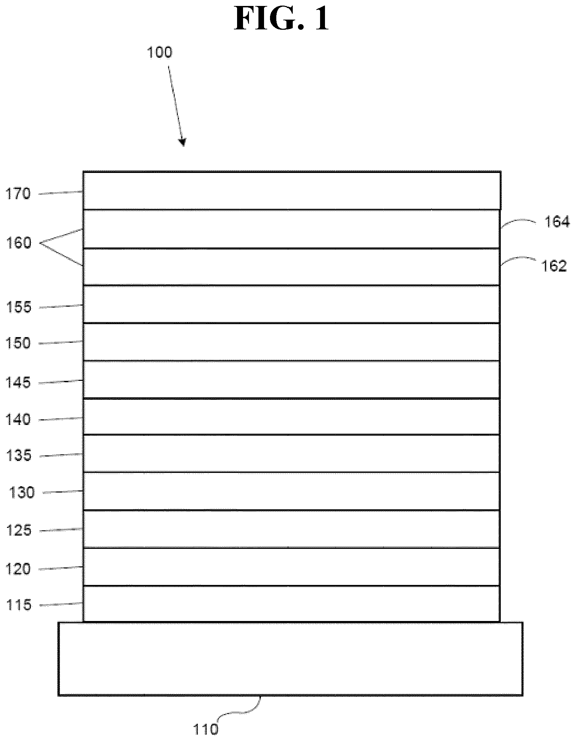

FIG. 1 shows an organic light emitting device.

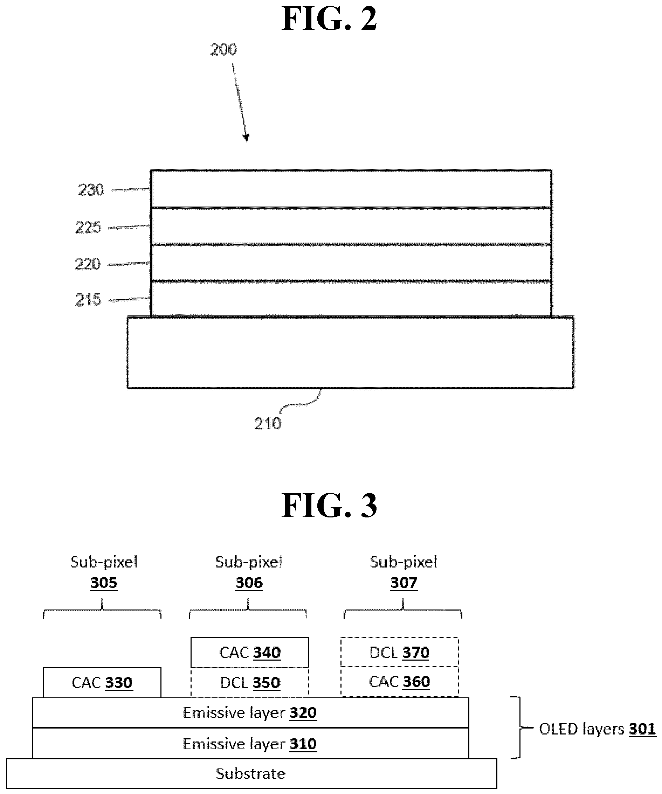

FIG. 2 shows an inverted organic light emitting device that does not have a separate electron transport layer.
FIG. 3 shows a cross-section of OLED sub-pixels according to embodiments disclosed herein, which includes multiple sub-pixels formed from blanket layers of emissive materials.

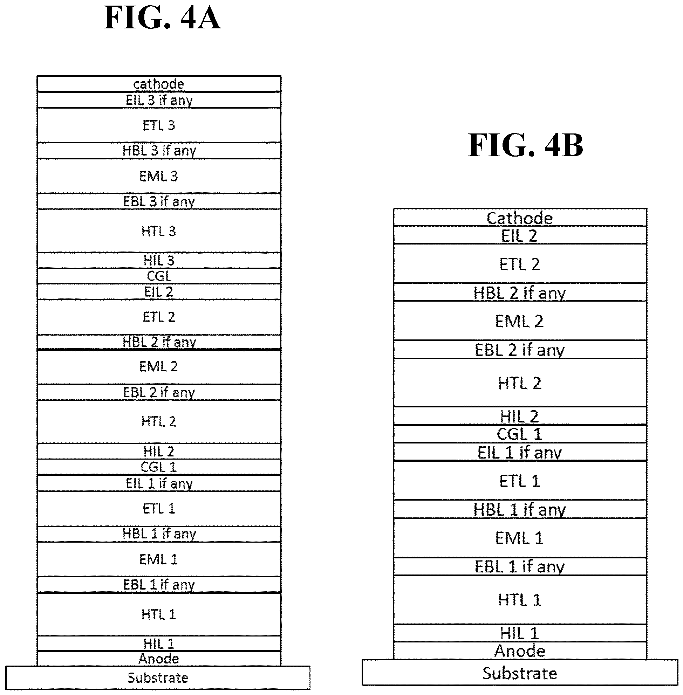

FIG. 4A shows an example stacked OLED structure according to embodiments disclosed herein.
FIG. 4B shows an example tandem stacked OLED structure according to embodiments disclosed herein.

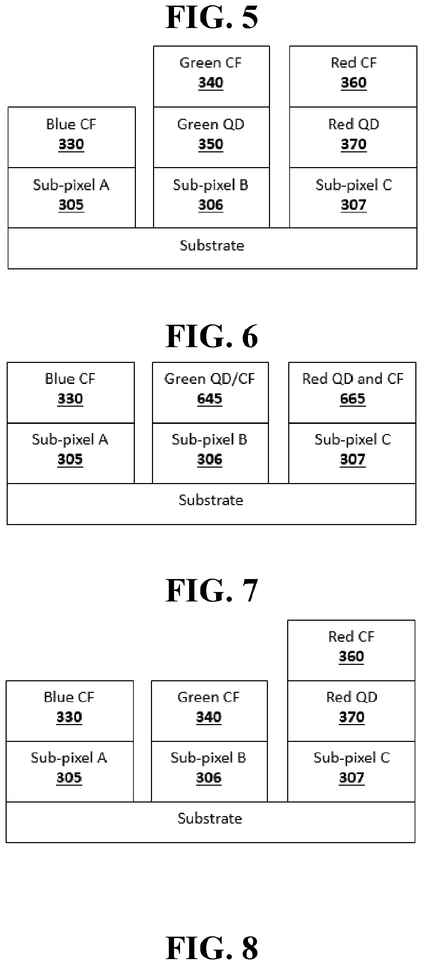

FIG. 5 shows a cross section of top emission OLED sub-pixels according to embodiments disclosed herein, in which emission from sub-pixel A is filtered to provide blue light. The emission from OLED B is partially or completely down-converted by a green quantum dot and filtered to provide green light. The emission from sub-pixel C is partially or completely down-converted by the red quantum dot and filtered to provide red light.
FIG. 6 shows a cross section of top emission OLED sub-pixels according to embodiments disclosed herein, in which emission from sub-pixel A is filtered to provide blue light. The emission from sub-pixel B is filtered and partially or completely down-converted by a green quantum dot to provide green light. The emission from sub-pixel C is partially or completely down-converted by a red quantum dot and filtered to provide red light.
FIG. 7 shows a cross section of top emission OLED sub-pixels according to embodiments disclosed herein, in which emission from sub-pixel A is filtered to provide blue light. The emission from sub-pixel B is filtered to provide green light. The emission from sub-pixel C is partially or completely down-converted by a red quantum dot and filtered to provide red light.
FIG. 8 shows a cross section of top emission OLED sub-pixels according to embodiments disclosed herein, in which emission from sub-pixel A is filtered to provide blue light. The emission from sub-pixel B is filtered to provide green light. The emission from sub-pixel C is partially or completely down-converted by a red quantum dot and filtered to provide red light.

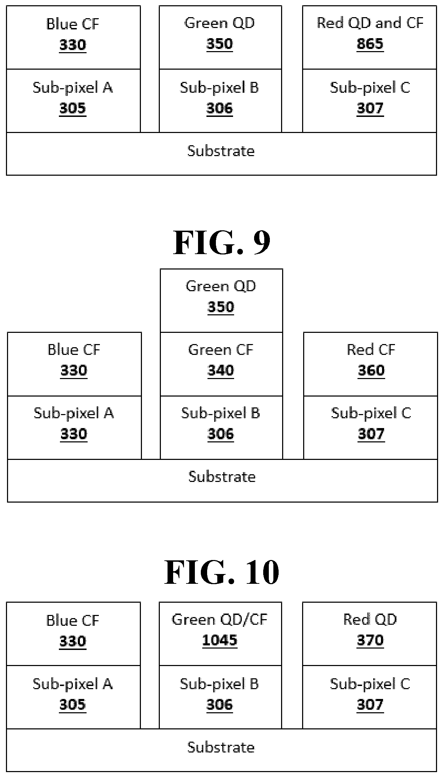

FIG. 9 shows a cross section of top emission OLED sub-pixels according to embodiments disclosed herein, in which emission from sub-pixel A is filtered to provide blue light. The emission from sub-pixel B is filtered and partially or completely down-converted by a green quantum dot to provide green light. The emission from sub-pixel C is filtered to provide red light.
FIG. 10 shows a cross section of top emission OLED sub-pixels according to embodiments disclosed herein, in which emission from sub-pixel A is filtered to provide blue light. The emission from sub-pixel B is filtered and partially or completely down-converted by a green quantum dot to provide green light. The emission from sub-pixel C is filtered to provide red light.

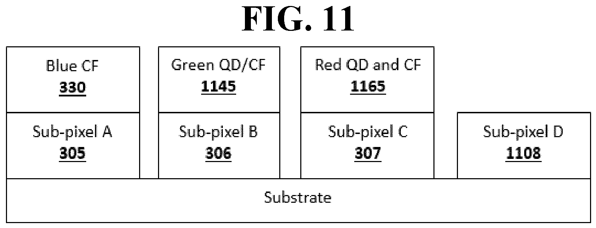

FIG. 11 shows a cross section of top emission OLED sub-pixels as disclosed herein, in which emission from sub-pixel A is filtered to provide blue light; emission from sub-pixel B is filtered and partially or completely down-converted by a green quantum dot to provide green light; emission from sub-pixel C is partially or completely down-converted by a red quantum dot and filtered to provide red light; and emission from sub-pixel D is unfiltered.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in US Pat. No. 7,279,704 at cols. 5-6, which are incorporated by reference.

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

In some embodiments disclosed herein, emissive layers or materials, such as emissive layer 135 and emissive layer 220 shown in FIGS. 1-2, respectively, may include quantum dots. An "emissive layer" or "emissive material" as disclosed herein may include an organic emissive material and/or an emissive material that contains quantum dots or equivalent structures, unless indicated to the contrary explicitly or by context according to the understanding of one of skill in the art. Such an emissive layer may include only a quantum dot material which converts light emitted by a separate emissive material or other emitter, or it may also include the separate emissive material or other emitter, or it may emit light itself directly from the application of an electric current, and converting electrical energy into light. Similarly, a color altering layer, color filter, upconversion, or downconversion layer or structure may include a material containing quantum dots, though such layer may not be considered an "emissive layer" as disclosed herein. In general, an "emissive layer" or material is one that emits an initial light based on conversion of electrical energy into light, which may be altered by another layer such as a color filter or other color altering layer that does not itself emit an initial light within the device, but may re-emit altered light of a different spectra content based upon the absorption of initial light emitted by the emissive layer.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, computer monitors, medical monitors, televisions, billboards, lights for interior or exterior illumination and/or signaling, heads-up displays, fully or partially transparent displays, flexible displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, and a sign. Various control mechanisms may be used to control devices fabricated in accordance with the present invention, including passive matrix and active matrix. Many of the devices are intended for use in a temperature range comfortable to humans, such as 18 C to 30 C, and more preferably at room temperature (20-25 C), but could be used outside this temperature range, for example, from -40 C to 80 C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

Display panels that use OLED-based pixel structures are becoming more common, and are often considered to have superior performance over other types of displays. However, in some cases other display panel technologies are considered to have adequate performance and/or lower cost. As such, it may be desirable to use OLED architectures that have simplified pixel structures to enable lower-cost, higher-performance display panels. Embodiments disclosed herein provide high-performance, simplified architectures that do not require pixel-level patterning of the OLED stack, by using an unpatterned stack that includes blue and at least one other color of emissive layers and/or materials. Other colors may be achieved in a full color display, for example, through the use of one or more color filters and down-conversion components such as quantum dot structures.

One approach to achieving an OLED display panel without using pixel-level patterning is to use a stack of multiple deep blue emissive layers and then use quantum dots or other structures to down-convert emitted blue light to green and red. In addition, color filters may be used to purify the red and green output. However, presuming a blue fluorescent emitter that is about 10% efficient and approximately a 40% down conversion efficiency of blue to green, the green sub-pixel in such a device will be only about 4% efficient. Furthermore, because visible white light is 60% green, the overall display will be very inefficient and will also require high drive currents, thus also leading to poor display lifetimes and/or only low luminance displays.

To address and/or prevent these and similar possible drawbacks to deep blue-only devices, embodiments disclosed herein may use one or more additional emissive materials, which may be arranged in unpatterned layers in a stack with one or more blue layers. For example, the addition or substitution of a layer such as a phosphorescent green layer in a two or three-blue-layer device may provide much higher-efficiency green and red pixels, thereby improving the overall display efficiency and lifetime. Furthermore, the increased efficiency obtained by the use of a phosphorescent green may allow for a reduced number of blue emissive layers or stacks, thus allowing for a lower voltage two-emissive-layer stack also with lower manufacturing cost and complexity. As another example, a red emissive layer may be used in addition to, or in place of, a blue-emitting layer, thereby allowing, for example, a BRB emissive stack.

As described in further detail below, quantum dots or other down-conversion layers or components may be used to down-convert blue light to green and/or red, and/or green light to red in the case of for example BGB, BG, or similar architectures. Such a configuration allows the red subpixel efficiency to benefit from down-converting both the green and blue light to red. A similar approach can be used for BRB, BR, and similar architectures.

In some cases, a fourth sub-pixel without any color filters may use the initial light generated by the stacked emissive layers with or without a quantum dot or other down-conversion component to produce a non-saturated emission color without the losses that typically occur when color filters or similar color-altering components are used.

FIG. 3 shows a generalized display arrangement architecture according to embodiments disclosed herein. Two or more emissive layers 310, 320 may be disposed over a substrate. The emissive layers preferably are unpatterned layers of organic emissive material to allow for fabrication of these layers without a fine metal mask or similar sub-pixel or pixel-scale masking. Other layers may be used in addition to the two emissive layers 310, 320, including additional emissive layers or other layers commonly used in OLEDs such as those shown in FIGS. 1-2 and 4A-4B, to provide a complete OLED stack 301. Individual sub-pixels 305, 306, 307 may be formed from the OLED stack and additional components as shown. The sub-pixels may be defined by a patterned layer of electrodes (not shown) that can be used to drive individual sub-pixels, as will be readily understood by one of skill in the art. Other than explicitly disclosed herein, no specific structure, arrangement, or composition of the other layers in the OLED stack 301 is required, and any appropriate layers may be used to provide the complete OLED stack 301. Unless specifically indicated, any of the emissive materials and layers disclosed herein may be phosphorescent or fluorescent, may exhibit thermally-activated delayed fluorescence (TADF), or may include electrically-driven quantum dots, in any combination known in the art. In some cases multiple layers of the same color, preferably the same distinct RGB color, may include different types of emissive materials such as where a phosphorescent blue layer and a fluorescent blue layer are used together in the OLED stack 301. In some embodiments it may be preferred for all emissive materials in the display arrangement to be phosphorescent.

The sub-pixels 305, 306, 307 may be used in conjunction with one another to provide a full-color pixel or similar arrangement, though they need not be addressed as a single pixel such as where sub-pixel rendering techniques are used in a larger display panel. For larger devices, any set of sub-pixels as shown in any of the drawings may be repeated in a pattern across an active area of the device, such as the emissive portion of a display panel.

The arrangement may include two or more color-altering components 330, 340, 360, such as color filters or similar components. In some cases only a single color filter may be used for a sub-pixel stack, such as color-altering component 330 in sub-pixel 305. Other sub-pixel stacks may use a down-conversion layer 350, 370 alone or in combination with a color-altering component such as a color filter. In the example arrangement shown in FIG. 3, sub-pixel 306 includes a color-altering component 340 and may include a down-conversion layer 350. The sub-pixel 307 may include a down-conversion layer 370 and/or a color-altering component 360. Unless explicitly specified, the color-altering components and/or down-conversion layers need not be arranged in any particular order relative to the substrate, though in some embodiments it may be preferred for some or all of the down-conversion layers to be disposed over any color-altering components in the same sub-pixel stack, or vice-versa. Generally each color-altering component and/or down-conversion layer will be disposed in a stack with the emissive OLED stack 301, but may not overlap other color-altering components or down-conversion layers other than those in a common color sub-pixel. For example, a green color filter may be disposed in a stack with a green quantum dot down-conversion layer to produce a green sub-pixel, but each component may not partially or entirely overlap a stack of adjacent sub-pixels, such as a blue or red sub-pixel.

Some embodiments disclosed herein may include two emissive layers 310, 320; two color-altering components 330, 340, and one or more down-conversion layers 350, 370. The color-altering components 330, 340 may be of different colors, for example to provide different colors of sub-pixels 305, 306, with or without the use of one or more down-conversion layers 350. Notably, embodiments disclosed herein may provide a full-color display arrangement, i.e., one that is capable of emitting the full range of visible color light, while using emissive layers of only two distinct RGB colors. For example, one emissive layer 310 may be a blue emissive layer, and the other emissive layer 320 may be red, green or blue color, preferably lighter or deeper blue (lower energy or higher energy) than the emissive layer 310. Additional emissive layers may be used of the same color as one of the emissive layers 310, 320 shown in FIG. 3. For example, one or more additional blue emissive layers may be used, though they may include one or more different emissive materials than the first blue layer 310 and may have different emission profiles within the blue spectrum. Similarly, one or more other red or green layers may be used in addition to the first layer 320, though they may include one or more different emissive materials than the first layer 320 and may have different emission profiles within the red or green spectrum. In some embodiments, it may be preferred to use a deep green emissive layer, either as the first layer 320, or in conjunction with another green emissive layer. Alternatively, it may be preferred to use a light green or a red emissive layer as the first layer 320. More generally, embodiments disclosed herein may include any number of emissive layers in the OLED stack 301, though it may be preferred that the total stack includes emissive layers of only two colors, preferably only two distinct RGB colors. Some or all of the additional emissive layers may be blanket layers that extend unbroken across multiple pixels and/or sub-pixels in the display arrangement.

In some cases it may be preferred for the emissive layers to have emission spectra that are particularly shifted toward the blue/green portion of the visible spectrum. It may be useful, therefore, to characterize such layers relative in the 1976 CIELUV color space and/or the 1931 (x,y) color space. In the 1976 CIELUV color space, it may be preferred for each emissive material in each of the emissive layers to have a u value of not more than about 0.2, preferably not more than about 0.17 or 0.15. Similarly, in the 1931 (x, y) color space, it may be preferred for each emissive material in each of the emissive layers to have a y value of not more than about 0.3-0.4, preferably not more than about 0.35. Restricting the emissive layers to one or more of these regions within the visible color space may allow for overall improvements to device complexity and/or efficiency and lifetime, because the photons generated by the layers may be used not only in blue sub-pixels but also in green and red sub-pixels through the use of color filters, down-conversion layers, and combinations thereof. In general this architecture may have efficiency and lifetime benefits because more of the light generated by the OLED layers can become useful light emitted by the display sub-pixels. In contrast, approaches in which the OLED sub-pixels generate white light that is subsequently heavily filtered to produce individual red, green and blue subpixels will be less efficient and typically will have lower lifetimes. This approach (that is this invention not the white plus color filter approach) is also more efficient than using only deep blue light as the initial source of light because the additional of a longer wavelength component of light can significantly improve the overall display efficiency by invoking less downconversion losses to produce the longer wavelength light. Further, the use of non-deep blue components may increase the lifetime of the display as deep blue emission is known to be the lifetime limiting component of OLED displays.

In some sub-pixel arrangements, a single layer or other component may provide both color filtering and down-conversion functions. Such a component may be described as a "color filter and down-conversion layer." More generally, any combination of color-altering component and down-conversion layer may be provided by one or more components, each of which may perform one or more color-altering functions. For example, FIG. 5 shows an arrangement in which the sub-pixels 306, 307 both include separate color filters 340, 360 and down-conversion layers 350, 370, while FIG. 6 shows a similar arrangement that includes components 645, 665 that provide both color filtering and down-conversion to the respective sub-pixels.

As previously noted, each sub-pixel 305, 306, 307 may include an OLED stack that incorporates any or all of the layers described in FIGS. 1-2, in any suitable arrangement to achieve a desired initial light generation for the sub-pixel. FIGS. 4A and 4B show example OLED stacks that include additional layers that may be used in the OLED stack 301. As with the emissive layers 310, 320, it may be preferred for some or all of the additional layers to be arranged in an unpatterned blanket layer across an active area of a display device. Examples of suitable layers may include electron injection layers, electron transport layers, hole transport layers, hole injection layers, charge generation layers, electron blocking layers, hole blocking layers, and the like. FIG. 4A shows an arrangement that includes three emissive layers EML1, EML2, EML3, which may each emit a single distinct RGB color. FIG. 4B shows an arrangement that includes two emissive layers EML1, EML2, which may each emit a single distinct RGB color. Where multiple emissive layers are used, a charge generation layer (CGL) may be disposed between adjacent emissive layers. The charge generation layer, as with other layers in the OLED stack 301, may be a blanket layer that extends across multiple pixels and subpixels in the active area of a display device. FIGS. 4A and 4B provide illustrative examples of the OLED stacks that may be used in individual sub-pixels. However, the present disclosure does not require any particular arrangement or number of such layers and, more generally, any suitable arrangement of layers as disclosed herein for use in an OLED may be used within the OLED layers 301.

It may be possible to improve the display efficiency and, in the case of an RGB full-color arrangement, the lifetime of red sub-pixels, by using a light blue phosphorescent layer instead of a fluorescent blue layer in the OLED layers 301. The light blue PHOLED layer can provide deep blue light by using a blue color filter, such as the color-altering component 330. If the corresponding deep blue component is not much less efficient than the fluorescent blue layer, then the blue sub-pixel efficiency will not be significantly reduced. Furthermore, some of the light blue emission will also provide photons that can be converted to green light in the green sub-pixel, such as by a color-altering component 340 and/or a down-conversion layer 350. This may increase the efficiency of the green sub-pixel. More importantly, the arrangement also may provide many more photons to excite quantum dots to produce red light for the red subpixel such as via a color-altering component 360 and/or down-conversion layer 370, thereby improving the display efficiency and the red sub-pixel lifetime. That is, it is expected that the use of a light blue PHOLED and a fluorescent deep blue emissive layer in the OLED layers 301 will provide many more blue photons for down-conversion via quantum dots than two fluorescent blue layers. Table 1 shows improved red lifetime for such an approach (Case 3), with lifetimes over three times the expected lifetime for a similar device that uses three fluorescent blue emissive layers, and over a 50% improvement of the red sub-pixel lifetime compared to a similar device that uses two blue and one green emissive layer (BGB).

Alternatively or in addition, a green-green-blue (GGB) architecture may provide additional improvements in efficiency and sub-pixel lifetime, particularly red sub-pixel lifetime. Such an arrangement includes three emissive layers in the OLED stack 301, two green and one blue. As previously disclosed, the green emissive layers may have different emissive materials and/or emission spectra from one another. It may be preferred for the green emissive layers to be phosphorescent and the blue to be fluorescent or phosphorescent. Such an arrangement, even with a fluorescent blue, shows a display efficiency of up to four times that of an all-fluorescent, three-blue stack and a significant increase in red sub-pixel lifetime, as shown by Case 4 in Table 1. The arrangement also shows about a 50% efficiency improvement relative to a similar architecture that uses a single green emissive layer instead of one blue layer (BGB), as shown in Case 2. As previously disclosed, the green emissive layers may include the same or different emissive materials, and may have the same host/dopant concentrations of emissive materials to optimize emission from two different positions within the overall OLED stack 301. In some embodiments, it may be preferred for at least one of the green layers to include a deep green emissive material.

Another improvement may be achieved by using two phosphorescent layers, such as phosphorescent light blue and green emissive layers. Such an arrangement is shown as Case 5 in Table 1. Because this arrangement requires only two depositions of emissive material, it will have the benefit of reduced OLED deposition costs. A deep blue color may be obtained from the blue color filter, possibly at a reduced efficiency compared to just using a deep blue fluorescent or phosphorescent blue. The simulations in Table 1 assume a 5% EQE deep blue arising from a filtered phosphorescent light blue, which is about half the efficiency of a fluorescent blue. However, this architecture also provides additional advantages elsewhere in the device, since most of the light blue photons (from phosphorescence) can be used for down-conversion to produce both green and red light. Details of the associated simulations are shown in Table 1.

Other arrangements may be used instead of, or in conjunction with the previously-disclosed arrangements to achieve a desired color gamut and/or to achieve other improvements in efficiency. For example, a yellow emissive layer may be used instead of one of the green emissive layers in the OLED stack of Case 4. Some configurations may allow for devices having a relatively higher color gamut that the all-fluorescent three-blue OLED stack, thereby allowing for four sub-pixel display architectures such as B1B2RG, BGYR, and the like.

Various combinations of color-altering and down-conversion layers may be used. In some cases, the use of specific components may allow for additional arrangements that would be inefficient or undesirable in other architectures. For example, because quantum dot down-conversion layers typically scatter light relative to the initial light transmitted into the layer, higher-strength microcavities maybe used, specifically in red and green sub-pixels used in conventional direct-view displays, because there are no viewing-angle concerns. This in turn may lead to narrower line widths and associated higher sub-pixel efficiencies.

FIGS. 5-11 show examples of specific arrangements of color-altering components, down-conversion layers, and OLED pixel stacks consistent with the general arrangement shown in FIG. 3. In each arrangement, sub-pixels 305, 306, 307 may include any suitable OLED stack 301 as previously disclosed. Preferably the stacks are provided by common blanket layers of OLED material that extend across the substrate and across the sub-pixels 305, 306, 307, with each sub-pixel being defined by a lower electrode in a patterned electrode layer as previously disclosed. Specifically, each sub-pixel may include at least two emissive layers 310, 320 of different colors, preferably distinct RGB colors. Additional blanket emissive layers may be used, each of which preferably is the same distinct RGB color as one of the initial two layers 310, 320. In each arrangement, unless otherwise specified, the sub-pixel stacks 305, 306, 207 include a blue blanket emissive layer and either a red or a green blanket emissive layer, but not both. The blue emissive layer may be a light blue layer or a deep blue layer. In embodiments that include more than two emissive layers, multiple different blue emissive layers may be used, including a blue emissive layer, a light blue emissive layer, and/or a deep blue emissive layer, in any combination. Similarly, where more than two emissive layers are used, multiple green or red emissive layers may be present, though they need not use the same emissive materials and/or host/dopant concentrations or have the same emission spectra within the respective colors, as previously disclosed. Some embodiments preferably include emissive layers of only two distinct RGB colors regardless of the total number of emissive layers in the stack, where emissive layers that emit the same distinct RGB color may include the same or different emissive materials and/or host/dopant concentrations.

FIG. 5 shows an example in which emission from one sub-pixel stack 305 is filtered with a blue color altering layer 330, such as a blue color filter, to provide blue light. That is, the blue color filter 330 may filter emission from the non-blue emissive layers in the common blanket stack shared by the three sub-pixels 305, 306, 307. In sub-pixel B 306, the emission from the common OLED stack is partially or completely down-converted by a green quantum dot 350, and filtered through a green color filter or other color-altering component 340 to provide green light. In sub-pixel C 307, the emission is partially or completely down-converted by a red quantum dot 370 and further filtered through a red color filter 360 to provide red light.

In some arrangements, a single component may be used both to down-convert and to filter light. FIG. 6 shows an arrangement similar to that of FIG. 5, where emission in sub-pixel B 306 is both filtered and partially or completely down-converted by a green quantum dot 645 to provide green light. In sub-pixel C, the emission from the OLED stack is both partially or completely down-converted by a red quantum dot 665 and filtered to provide red light. Functionally, the green quantum dot 645 may achieve the same or a similar result as the separate down-conversion quantum layer 350 and the green color-altering component 340 in FIG. 5, and the red quantum dot 665 may achieve the same or a similar result as the red quantum dot 370 and red filter 360 in FIG. 5.

Some embodiments that include red, green, and blue sub-pixels may not use down-conversion layers for both the green and red sub-pixels. FIG. 7 shows an example configuration in which sub-pixel B 306 is filtered with a green color filter 340 to provide green light, but no down-conversion layer is present. The emission from sub-pixel C 307 is partially or completely down-converted by a red quantum dot 370 and filtered with a red color filter 360 to provide red light.

Some embodiments may include other combinations of down-conversion layers, color filters, and/or quantum dots that provide both down-conversion and color filtering. FIG. 8 shows an example in which sub-pixel B 306 includes a green quantum dot 350 that filters light emitted by the stacked OLED to produce green light. In sub-pixel C 307, the light is partially or completely down-converted and filtered by a red quantum dot 865 to provide red light. FIG. 9 shows another example in which the sub-pixel B 306 includes a green color filter 340 and a green quantum dot down-conversion layer 350 that partially or completely down-converts the filtered light to provide green light. The emission from sub-pixel C 307 is filtered by a red color filter 360 to provide red light. FIG. 10 shows another example in which sub-pixel B includes a green quantum dot down-conversion layer 1045 that both filters and partially or completely down-converts light emitted by the OLED stack to provide green light. Sub-pixel C 307 includes a red quantum dot 370 that down-converts light emitted by the OLED stack to provide red light.

As previously described with respect to FIG. 3, some embodiments may include an additional sub-pixel that emits the unfiltered light produced by the OLED stack. FIG. 11 shows such an example, in which a sub-pixel D 1108 does not include any color filters, quantum dots, or other color-altering layers or down-conversion layers. As such, the sub-pixel D 1108 will emit light of the same spectrum as the light initially generated by the OLED stack 301. Generally in an arrangement such as that shown in FIG. 11, the other sub-pixels may have any arrangement of color-altering layers and/or down-conversion layers as previously disclosed. In this example, sub-pixel A 305 includes a blue color filter 330 to provide blue light; sub-pixel C 306 includes a green quantum dot 1145 to filter and partially or completely down-convert light emitted by the OLED stack to provide green light; and sub-pixel C 307 includes a red quantum dot 1165 that filters and partially or completely down-converts the generated light to provide red light.

Embodiments disclosed herein may use different optimization criteria than those used in conventional RGB displays based on color filters or conventional side-by-side architectures. For example, the use of an OLED stack having two colors of emissive layers in conjunction with down-conversion layers to produce an AMOLED display may allow for a wider variety of optimization options. This is due to the fact that light from any emissive material may provide photons for both a blue sub-pixel as well as red and/or green sub-pixels through down-conversion. In contrast, conventional devices typically must optimize device structure and materials around the fact that photons emitted by emissive regions within each sub-pixel are only used to produce light emitted by the same sub-pixel.

Embodiments disclosed herein provide full-color display arrangements that may be used to provide sub-pixels and/or pixels in a display panel or similar device. In some cases the sub-pixel arrangements disclosed may be addressed via circuitry that treats groups of three or more sub-pixels as a single pixel. Alternatively, sub-pixel rendering techniques and circuitry may be used. The arrangements may be used in any OLED device architecture and arrangement, including bottom or top emitting OLEDs and devices incorporating the same, and such devices may have various characteristics such as being flexible, being rollable, being foldable, being stretchable, and being curved. In some embodiments, the device may be transparent or semi-transparent. In some embodiments, the device may include one or more layers comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments of the emissive region, the emissive region further comprises a host.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

The organic layer can also include a host. In some embodiments, two or more hosts are preferred. In some embodiments, the hosts used maybe a) bipolar, b) electron transporting, c) hole transporting or d) wide band gap materials that play little role in charge transport. In some embodiments, the host can include a metal complex. The host can be an inorganic compound.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

Various materials may be used for the various emissive and non-emissive layers and arrangements disclosed herein. Examples of suitable materials are disclosed in U.S. Patent Application Publication No. 2017/0229663, which is incorporated by reference in its entirety.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

### HIL/HTL:

A hole injecting/transporting material to be used in the present invention is not particularly limited, and any compound may be used as long as the compound is typically used as a hole injecting/transporting material.

### EBL:

An electron blocking layer (EBL) may be used to reduce the number of electrons and/or excitons that leave the emissive layer. The presence of such a blocking layer in a device may result in substantially higher efficiencies, and or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

### HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and or higher triplet energy than the emitter closest to the HBL interface. In some embodiments, the HBL material has a lower HOMO (further from the vacuum level) and or higher triplet energy than one or more of the hosts closest to the HBL interface.

### ETL:

An electron transport layer (ETL) may include a material capable of transporting electrons. The electron transport layer may be intrinsic (undoped), or doped. Doping may be used to enhance conductivity. Examples of the ETL material are not particularly limited, and any metal complexes or organic compounds may be used as long as they are typically used to transport electrons.

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

### EXPERIMENTAL

Table 1 shows five different architectures according to embodiments disclosed herein and their simulated performance in terms of efficiency and lifetime. The top half of Table 1 shows results of efficiency simulations of the display based on the current density for each sub-pixel required to achieve the target luminance shown in the Table. Below these currents, the simulated power efficiency (PE) is shown for each architecture. Finally, the lifetime calculations at the bottom of the table show the projected LT95 lifetimes in hours for each of the limiting colors of blue and red, i.e., the lifetime to 95% of the original lifetime when driven at the specified luminance. As can be seen from the data (note that the same stack is used for all three sub-pixel colors), the limiting lifetime typically is the red sub-pixel. It is desirable to increase the lifetime of the color with the lowest lifetime to improve the overall display lifetime. With a comparable device that uses three fluorescent blue emissive layers, it can be seen that the red sub-pixel lifetime severely limits the overall display lifetime, and adding phosphorescence greatly improves the red sub-pixel lifetime. Fluorescent layers are assumed to have 10% EQE and phosphorescent layers are 25% EQE.

**Table 1: Simulated performance of devices and sub-pixels**

| | | Case 1 | Case 2 | Case 3 | Case 4 | Case 5 |
|---|---|---|---|---|---|---|
| | | J | J | J | J | J |
| | ^{∗∗∗} L [cd/m²] | [mA/cm²] | [mA/cm²] | [mA/cm²] | [mA/cm²] | [mA/cm²] |
| B | 1000 | 4.2 | 7.8 | 7.8 | 15.6 | 31.3 |
| G | 6000 | 16.1 | 5.9 | 5.9 | 3.6 | 5.5 |
| R | 3000 | 46.6 | 31.1 | 23.3 | 23.3 | 28.0 |
| | | | | | | |
| PE [Lm/W] | | 7.0 | 17.2 | 17.4 | 27.5 | 24.0 |
| | | | | | | |
| Same pixel areas | B pixel LT95 (hours) | 10,392 | 4,048 | 4,048 | 1,431 | 506 |
| (33% each) | R pixel LT95 (hours) | 213 | 437 | 673 | 673 | 535 |

In Table 1, the following device architectures are shown for the emissive layers in the OLED stack, which correspond to OLED stack 301 in FIGS. 3 and 5-11:
Case 1: Three fluorescent blue layers
Case 2: One phosphorescent green and two fluorescent blue layers
Case 3: One fluorescent blue layer, one phosphorescent green layer and one phosphorescent deep blue layer
Case 4: One fluorescent blue layer and two phosphorescent green layers
Case 5: One light blue phosphorescent layer and one green phosphorescent layer

The following are several non-limiting examples of the disclosure:
Example 1. A full-color display arrangement for an organic light emitting diode (OLED) device, the full-color display arrangement comprising:
   a first emissive layer comprising a first blue first organic emissive material;
   a second emissive layer disposed in a stack with the first emissive layer and comprising a second organic emissive material, wherein the second organic emissive material comprises a green organic emissive material, a red organic emissive material, or a second blue organic emissive layer having a peak wavelength at least 4nm different than the first blue organic emissive layer ;
   a first color-altering component disposed in a stack with the first and second emissive layers;
   a second color-altering component configured to produce a different color than the first color-altering component; and
   a first down-conversion layer;
   wherein the full-color display arrangement comprises emissive materials of not more than two distinct RGB colors.
Example 2. The full-color display arrangement of Example 1, wherein the second organic emissive material is a green emissive material, and wherein each of the first and second emissive materials has a 1976 CIELUV u value of not more than 0.17.
Example 3. The full-color display arrangement of Example 1, wherein the second organic emissive material is a red emissive material, and wherein each of the first and second emissive materials has a 1931(x,y) color space y value of not more than 0.35.
Example 4. The full-color display arrangement of any of Examples 1 to 3, wherein the down-conversion layer is a red quantum dot layer or a green quantum dot layer.
Example 5. The full-color display arrangement of any of Examples 1 to 4, further comprising a charge generation layer disposed between the first and second emissive layers.
Example 6. The full-color display arrangement of any of Examples 1 to 5, further comprising a second down-conversion layer of a different emission color than the first down-conversion layer.
Example 7. The full-color display arrangement of any of Examples 1 to 6, further comprising a third emissive layer disposed in a stack with the first and second organic emissive layers.
Example 8. The full-color display arrangement of Example 7, wherein the third organic emissive material is different than the first organic emissive material.
Example 9. The full-color display arrangement of Example 7 or 8, wherein the third organic emissive material comprises a light blue or deep blue organic emissive material.
Example 10. The full-color display arrangement of any of Examples 1 to 9, wherein the second emissive layer comprises a green emissive material and the first down-conversion layer comprises a quantum dot layer that down-converts light emitted by the first organic emissive layer and/or the second organic emissive layer to red light.
Example 11. The full-color display arrangement of any of Examples 1 to 10, wherein the first color-altering component is disposed in a stack with a first portion of the first and second emissive layers and the second color-altering component is disposed in a stack with a second portion of the first and second emissive layers that does not overlap the first portion of the first and second emissive layers.
Example 12. The full-color display arrangement of any of Examples 1 to 11, wherein the first down-conversion layer is disposed in a stack with the first and second emissive layers and either the first color-altering component or the second color-altering component.
Example 13. An OLED display device comprising:
   a first organic emissive layer comprising a first organic emissive material that emits light having a 1976 CIELUV u value of not more than 0.17;
   a second organic emissive layer comprising a second organic emissive material that emits light having a 1976 CIELUV u value of not more than 0.17and having a different color than the first organic emissive material; and
   a first color-altering component disposed and arranged to alter light emitted by at least one of the first and second organic emissive layers.
Example 14. The device of Example 13, wherein each of the first and second organic emissive layers is an unpatterned blanket layer that extends across an active area of the device.
Example 15. The device of Example 13 or 14, wherein the first organic emissive material, the second organic emissive material, or both comprise a thermally-activated delayed fluorescence (TADF) material.

It is understood that the various embodiments described herein are by way of example only, and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

## Claims

1. A full-color display arrangement for an organic light emitting diode (OLED) device, the full-color display arrangement comprising:
a first emissive layer comprising a first blue first organic emissive material;
a second emissive layer disposed in a stack with the first emissive layer and comprising a second organic emissive material, wherein the second organic emissive material comprises a green organic emissive material;
a first color-altering component disposed in a stack with the first and second emissive layers;
a second color-altering component configured to produce a different color than the first color-altering component; and
a first down-conversion layer, wherein the first down-conversion layer down-converts light emitted by the first organic emissive layer and/or the second organic emissive layer to red light;
wherein the full-color display arrangement comprises emissive materials of not more than two distinct Green or Blue colors.

2. The full-color display arrangement of claim 1, comprising a second blue organic emissive layer having a peak wavelength at least 4nm different than the first blue organic emissive layer.

3. The full-color display arrangement of any of claims 1 to 2,wherein the first down-conversion layer comprises a quantum dot layer that down-converts light emitted by the first organic emissive layer and/or the second organic emissive layer to red light.

4. The full-color display arrangement of any of claims 1 to 3, further comprising one or more further down-conversion layers configured to convert blue light to red light and/or configured to convert green light to red light.

5. The full-color display arrangement of any of claims 1 to 4, further comprising a third emissive layer disposed in a stack with the first and second organic emissive layers; and optionally wherein the third organic emissive material is different than the first organic emissive material.

6. The full-color display arrangement of claim 5, wherein the third organic emissive material comprises a light blue or deep blue organic emissive material.

7. The full-color display arrangement of any of claims 1 to 6, wherein the first blue first emissive material comprises a light blue phosphorescent material.

8. The full-color display arrangement of any of claims 1 to 7, wherein the first color-altering component is disposed in a stack with a first portion of the first and second emissive layers and the second color-altering component is disposed in a stack with a second portion of the first and second emissive layers that does not overlap the first portion of the first and second emissive layers.

9. The full-color display arrangement of any of claims 1 to 8, wherein the first down-conversion layer is disposed in a stack with the first and second emissive layers and either the first color-altering component or the second color-altering component.

10. The full-color display arrangement of any of claims 1 to 9, wherein at least one of the emissive layers comprises a phosphorescent material.

11. An OLED display device comprising:
a first organic emissive layer comprising a first organic emissive material that emits light having a 1976 CIELUV u value of not more than 0.17, wherein the first emissive layer comprising a first blue first organic emissive material;
a second organic emissive layer comprising a second organic emissive material that emits light having a 1976 CIELUV u value of not more than 0.17and having a different color than the first organic emissive material, and wherein the second organic emissive material comprises a green organic emissive material; and
a first color-altering component disposed and arranged to alter light emitted by at least one of the first and second organic emissive layers to red light.

12. The device of claim 11, wherein each of the first and second organic emissive layers is an unpatterned blanket layer that extends across an active area of the device.

13. The device of claim 11 or 12, wherein the first organic emissive material, the second organic emissive material, or both comprise a thermally-activated delayed fluorescence (TADF) material.

14. The device of any of claims 11 to 13, wherein the first organic emissive layer, the second organic emissive layer, or both comprise a phosphorescent material

15. The device of any of claims 11 to 14, wherein the first and second organic emissive layers provide a plurality of sub-pixels which together provide a full-color display.
